Europäisches Patentamt

(19) European Patent Office

(11) Numéro de publication: **0 119 459**

Office européen des brevets

**B1**

(12) **FASCICULE DE BREVET EUROPÉEN**

(45) Date de publication du fascicule du brevet:
21.09.88

(21) Numéro de dépôt: **84101468.1**

(22) Date de dépôt: **13.02.84**

(51) Int. Cl.⁴: **C 23 C 14/16,** C 23 C 14/34,
G 04 B 37/00

(54) **Pièce comprenant un substrat muni d'un revêtement dur et résistance à la corrosion.**

(30) Priorité: 17.02.83 CH 879/83

(43) Date de publication de la demande:
26.09.84 Bulletin 84/39

(45) Mention de la délivrance du brevet:
21.09.88 Bulletin 88/38

(84) Etats contractants désignés:
AT BE CH DE FR GB IT LI NL SE

(56) Documents cité:
EP-A-0 038 294
EP-A-0 074 322
AU-A-507 748

METAL FINISHING, vol. 74, août 1976, pages 32-34,40
THIN SOLID FILMS, vol. 45, no. 2, 1977, pages 397-406
THIN SOLID FILMS, vol. 40, 1977, pages 365-374
CHEMICAL ABSTRACTS, vol. 81, no. 4, 29 juillet
1974, page 179, no. 16060j, Columbus, Ohio, US
"Ullmans Encyklopädie der technischen Chemie",
1977, Band 14, p. 283

(73) Titulaire: **ETA S.A. Fabriques d'Ebauches, Schild-**
**Rust- Strasse 17, CH- 2540 Grenchen (CH)**

(72) Inventeur: **Bergmann, Erich, Lyssstrasse 61, CH-**
**2560 Nidau (CH)**

(74) Mandataire: **Barbeaux, Bernard, ICB Ingénieurs**
**Conseils en Brevets SA Passage Max. Meuron**
**6, CH- 2001 Neuchâtel (CH)**

## Description

La présente invention concerne la fabrication d'une pièce comprenant un substrat muni d'un revêtement dur et résistant à la corrosion, et elle se rapporte plus particulièrement à la fabrication de telles pièces constituant un article de bijouterie, comme par exemple un bracelet ou une boîte de montre.

Il est connu, notamment dans le domaine des boîtes de montres, de revêtir une boîte d'un revêtement dur, qui la met à l'abri de la corrosion et des rayures, ou de l'usure consécutive au contact de la boîte avec des objets extérieurs, ou les vêtements du porteur de la montre. Par exemple, le EP-A-0 038 294, ou le CH-A-631 040 se rapportent à des revêtements durs à base de nitrure de titane, qui présentent, outre leur dureté, l'avantage de présenter une couleur très voisine de celle de l'or.

Toutefois, bien que les revêtements ainsi obtenus présentent une très bonne résistance à l'usure, leur tenue aux chocs, par exemple contre des surfaces dures, n'est pas en rapport avec cette résistance à l'usure. En effet, les revêtements appliqués étant relativement minces, de l'ordre de quelques dizaines de microns, la dureté de la pièce revêtue est sensiblement celle du substrat, qui peut être en laiton ou en acier, et il peut alors se produire un enfoncement du substrat, qui entraîne une détérioration du revêtement dur, et de l'aspect de la pièce.

Pour pallier cet inconvénient, on peut mettre en oeuvre un substrat réalisé lui-même en une matière dure, mais alors le prix de revient de la pièce, et de son usinage avant revêtement deviennent prohibitifs.

Dans un article de la revue "Thin Solid Films", 45(1977) 397 - 406, J.A. Thornton et D.G. Cornog font l'analyse d'un revêtement dur obtenu à l'aide de la technique du "dépôt assisté par un plasma" (plasma assisted deposition). Dans ce cas, le dépôt est réalisé à partir d'un acier austénitique au manganèse de type Hadfield. Selon la température de dépôt, les revêtements obtenus peuvent présenter une phase de cémentite (Fe$_3$C) dispersée. Il en résulte une dureté de la couche déposée s'échelonnant entre 350 et 750 kg m$^2$ (Knoop hardness).

Bien que cette valeur de dureté soit déjà fort appréciable, il s'est avéré que dans certains cas elle n'est pas suffisante. Il en est ainsi notamment des boîtes de montre.

L'invention a donc pour but de proposer un procédé de fabrication d'une pièce munie d'un revêtement dont la dureté est nettement plus élevée que celle réalisée par un revêtement de la technique antérieure et dont les conditions d'obtention sont compatibles avec une industrialisation à grande échelle.

Elle a donc pour objet un procédé de fabrication d'une pièce comprenant un substrat métallique muni d'un revêtement dur et résistant à la corrosion, dur consistant à appliquer sur ce substrat métallique de cette pièce un revêtement métallique par dépôt assisté au plasma (plasma assisted deposition) d'un alliage, dans une enceinte dans laquelle règne une atmosphère de gaz inert caractérisé en ce que ledit alliage est un Stellite, et en ce que le procédé consiste, en outre, à maintenir lors du dépôt la température du substrat et la pression de l'atmosphère de gaz inerte à des valeurs correspondant à un point de la zone T du diagramme proposé par J.A. Thornton dans la revue Ann. Rev. Mater. Sci. 1977, page 242, de manière à conférer audit revêtement une distribution ultrafine de particules dures dans une matrice d'alliage et une structure compacte.

Dans la présente description, on entend par un Stellite un alliage à base de cobalt, de chrome, de tungstène et de carbone (voir Ullmans Encyklopädie der technische Chemie, 1977, Band 14, page 283).

Il s'est avéré qu'en utilisant un alliage ainsi défini et en choisissant un point dans la zone T du diagramme de Thornton, c'est-à-dire une relation bien déterminée entre la température du substrat et la pression du gaz inerte dans l'enceinte de dépôt, on obtient un revêtement dont la dureté atteint des valeurs situées entre 1200 et 1500 HV 10 p, tout en présentant des qualités optiques excellentes. Par ailleurs, le revêtement peut être appliqué dans des conditions de température peu critiques étant donné que la zone T pour l'alliage défini ci-dessus est relativement large.

L'article précité de J.A. Thornton paru dans la revue Ann. Rev. Mater Sci. traite essentiellement de dépôts métalliques obtenus à l'aide d'un plasma et examine les propriétés physiques de la croissance et de la structure des couches de revêtement obtenues à l'aide de ces dépôts.

A cet effet, Thornton développe une technique de représentation de la microstructure des couches en se basant sur des "modèles de zones" déjà établis antérieurement. Thornton apporte une autre notion pour décrire ces microstructures en tenant compte non seulement de la température du substrat mais également de la pression du gaz inerte régnant dans l'enceinte de travail durant le dépôt. C'est ainsi que l'auteur arrive à déterminer une zone "T" dans laquelle la couche présente un réseau dense de grains fibreux peu définis. Une telle structure est particulièrement appropriée pour réaliser des pièces devant présenter une dureté très élevée à la condition que, selon l'invention, on emploie un alliage pour la matière de travail qui est de la nature définie ci-dessus.

L'invention sera bien comprise à la lecture de la description suivante, faite en relation avec les dessins joints, parmi lesquels:

- la figure 1 est une vue schématique en coupe d'une pièce obtenue selon le procédé de l'invention;
- la figure 2 est une vue schématique d'une installation permettant de réaliser le revêtement de la pièce de la figure 1;
- les figures 3 et 4 sont des micrographies de couches dures selon l'invention;
- la figure 5 est une vue analogue à celle de la figure 4 d'une couche ne présentant pas les caractéristiques de l'invention;

2

- la figure 6 est une vue en perspective montrant le diagramme de Thornton utilisé dans l'invention.

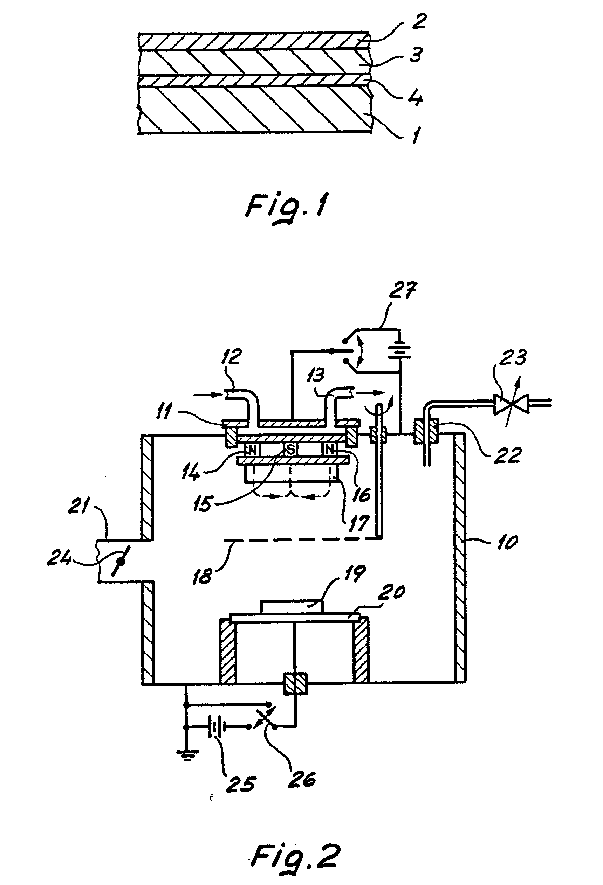

Dans la figure 1, on a représenté schématiquement en coupe une pièce comprenant un substrat 1, et un revêtement dur formé d'une couche extérieure de décoration 2 résistante à l'usure et à la corrosion et d'une couche métallique 3, de grande dureté, qui assure à l'ensemble de la pièce la résistance à l'enfoncement requise. Le substrat 1 est réalisé en une matière métallique facile à usiner, par exemple en laiton ou en acier. Dans le cas de l'utilisation du laiton, une couche intermédiaire 4 formant barrière de diffusion est disposée entre le substrat 1 et la couche métallique 3, de façon à empêcher le zinc du laiton de migrer vers les couches extérieures, ce qui nuirait à l'aspect de la pièce. Il s'agit de préférence d'une couche de 0,1 à 0,5 μm d'épaisseur de molybdène. La couche extérieure 2 peut être formée en tout matériau résistant à l'usure, mais l'utilisation d'une couche de 1 à 2 μm d'épaisseur de nitrure de titane est particulièrement recommandée pour les applications en bijouterie. Enfin, la couche métallique 3, d'une épaisseur de 2 à 100 μm, de préférence comprise entre 5 et 15 μm et qui se deistingue par une distribution ultrafine de matériaux durs, est un Stellite. De préférence, on utilise un alliage dont la composition est de 2 à 3 % de carbone, 40 à 55 % de cobalt, 25 à 35 % de chrome, 10 à 20 % de tungstène, 15 % de molybdène, et, éventuellement, 4 % de fer, de nickel et de titane.

L'expérience a montré que lorsque ces alliages sont déposés par les méthodes du type "Dépôt assisté par plasma" (plasma assisted deposition)", comme par exemple la pulvérisation cathodique effectuée au moyen d'un magnétron plat ou d'un faisceau ionique, la couche formée à partir d'une cible de Stellite comportait une matrice inoxydable, dans laquelle est formée une distribution ultrafine de carbure de chrome ou de tungstène, qui assure une dureté très importante à l'ensemble. Par distribution ultrafine, on entend que les fragments de matériaux durs répartis dans la matrice présentent une taille inférieure à 0,01 μm et de préférence inférieure à 0,005 μm. La dureté de la couche ainsi obtenue est alors de l'ordre de 1200 à 1500 HV 10 p, alors que la dureté du Stellite massif n'est que de 750 HV 10 p. Le procédé de dépôt, connu en soi, mais appliqué au matériau précité, détruit la structure en plaquettes ou dendritique du carbure de chrome, qui est normalement la cause de la fragilité des alliages inoxydables, et qui ne peut pas se former au moment de l'élaboration de la couche.

Dans la figure 2, on a représenté de façon schématique une installation permettant de réaliser une couche métallique à distribution ultrafine de matériaux durs selon l'invention. On utilise à cet effet une enceinte à vide 10, à la partie supérieure de laquelle est disposé un magnétron plat 11. Le magnétron plat comporte une cathode refroidie par un circuit de refroidissement d'eau 12, 13 et des aimants permanents 14 à 16 créant un champ magnétique destiné à confiner un plasma à proximité immédiate d'une cible 17 fixée sur la cathode 11. Un écran amovible 18 peut être interposé entre la cible 17 et le substrat 19 destiné à être revêtu, qui est déposé sur une électrode de substrat 20. L'enceinte 10 peut être évacuée au moyen d'une pompe turbomoléculaire non représentée et raccordée à une ouverture 21, et une pression d'argon ou d'un autre gaz inerte peut être établie par l'intermédaire d'une buse 22, munie d'une vanne de précision 23, et d'une vanne d'étranglement 24 montée dans l'ouverture 21. Sur le plan électrique, un circuit de polarisation 25 muni d'un interrupteur 26 permet de porter le substrat 19 à un potentiel négatif par rapport à celui de l'enceinte lorsque l'on désire en effectuer un décapage avant dépôt. En outre, un circuit de polarisation 27 permet de porter la cible 17 à un potentiel négatif de l'ordre de quelques centaines de volts.

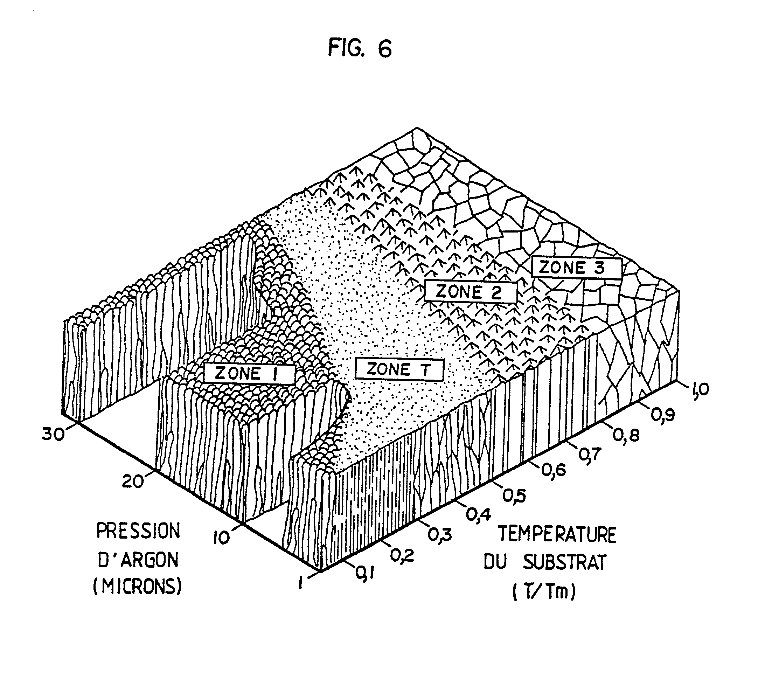

Pour réaliser une couche présentant une distribution ultrafine de matériaux durs selon l'invention, par exemple sur un substrat 19 en acier, la procédure à suivre est la suivante. Tout d'abord, le substrat est placé sur l'électrode de substrat 20, après avoir été poli. Une cible 17, constituée par exemple par une plaquette de Stellite fritté ou coulé sous vide, est fixée sur la cathode à magnétron plat 11. L'enceinte 10 est alors évacuée, et l'on y établit une pression d'argon. Le substrat est soumis à un décapage ionique. Ensuite, l'écran amovible 18 est retiré et la cible 17 est polarisée. Le matériau est alors éjecté de la cible 17 par bombardement ionique et projeté sur le substrat 19. La vitesse de dépôt, de l'ordre de 0,1 à 10 microns par minute, dont dépend la température du substrat, est déterminée, compte tenu de la pression d'argon, de manière que ces deux derniers paramètres définissent un point compris dans la zone dite T du diagramme proposé par J.A. Thornton (Ann. Rev. Mater. Sci. 1977.7: 239 - 260) (voir figure 6). Dans cette zone dite T du diagramme de Thornton, les dépôts présentent une structure régulière et compacte, conduisant à une rugosité minimale de la surface. Pour un dépôt de couche de Stellite, les conditions opératoires sont les suivantes: tension de polarisation du substrat: - 80 V; tension de polarisation de la cathode magnétron: 420 V;

pression d argon 0,107 Pa. De préférence, la cible utilisée dans ce dernier cas est une plaque de Stellite obtenue par coulage sous vide, selon un procédé conventionnel.

L'intérêt d'utiliser le Stellite pour réaliser la couche à distribution ultrafine de matériaux durs est qu'il présente une dureté très élevée sous la forme de couches minces, de l'ordre de 1500 HV, et que la zone T pour cet alliage est particulièrement large, ce qui rend les conditions opératoires peu critiques.

Après le dépôt de la couche à distribution ultrafine de matériaux durs, on peut procéder à son recouvrement par une couche décorative par exemple de TiN, selon le procédé bien connu.

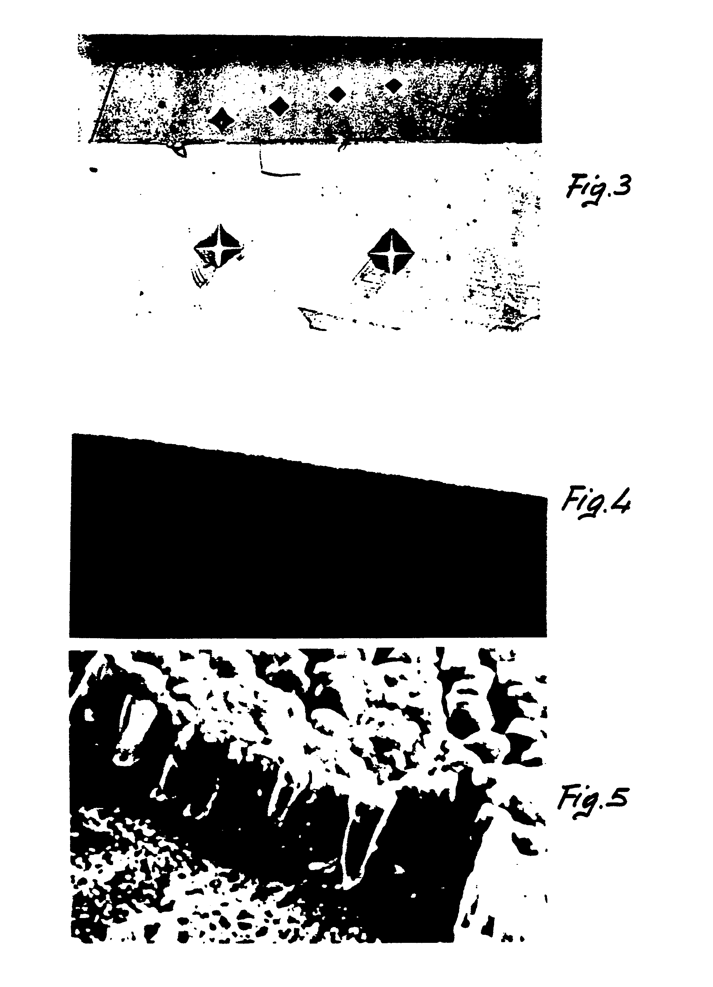

La micrographie de la figure 3 montre avec un grossissement de 800 x une coupe oblique d'un substrat de laiton revêtu d'une couche d'environ 5 μm d'épaisseur de Stellite déposée comme indiqué ci-dessus. Cette couche permet d'obtenir une dureté superficielle de $X_5 = 1736$ HV 10 p, alors que la dureté du substrat n'est que de $X_2 = 132$ HV 10 p. Les différentes empreintes de microduromètre montrent que la dureté de la couche s'accroît lorsque l'on s'éloigne de l'interface, de la manière indiqué dans le tableau suivant:

**0 119 459**

| Empreinte (de gauche à droite) | Distance réelle par rapport à l'interface | Dureté |
|---|---|---|
| 1 | 1,41 μm | 515 HV 10 p |
| 2 | 2,38 " | 804 " |
| 3 | 3,13 " | 1251 " |
| 4 | 3,69 " | 1355 " |

Enfin, la figure 3 montre encore qu'avec le grossissement du microscope, la couche de Stellite paraît parfaitement homogène, la taille des fragments de matériaux durs dispersés étant inférieure à 0,01 μm. Au contraire, un alliage de Stellite massif observé à l'état solidifié après coulée avec le même grossissement révèle une structure de phases nettement séparées, qui conduit notamment à une moins bonne résistance chimique du fait de réactions électrochimiques attaquant les joints de grain.

La figure 4 est une photographie d'une cassure d'un substrat revêtu, observée au microscope électronique avec un grossissement de 7000 x. Cette photographie montre une morphologie régulière, et compacte, les limites des grains n'étant pas visibles. Cette structure est caractéristique de la zone T du diagramme de Thornton, et elle conduit à des revêtements d'aspect parfait en raison d'une rugosité minimale de la surface.

A titre de comparaison, la figure 5 est une vue analogue à celle de la figure 4 d'une couche métallique ne présentant pas la structure de zone T du diagramme de Thornton. Cette structure, caractéristique de la zone 1 du même diagramme, se distingue par des colonnes nettement séparées, réparties de façon non compacte, et produisant à la surface un relief qui nuit très fortement à l'esthétique de la pièce revêtue.

**Revendications**

1. Procédé de fabrication d'une pièce comprenant un substrat métallique muni d'un revêtement dur et réstitant à la corrosion, consistant à appliquer sur ce substrat métallique (1) de cette pièce un revêtement métallique (3) par dépôt assisté au plasma (plasma assisted deposition) d'un alliage, dans une enceinte dans laquelle règne une atmosphère de gaz inerte, caractérisé en ce que ledit alliage est un Stellite, et en ce que le procédé consiste en outre à maintenir lors du dépôt la température du substrat et la pression de l'atmosphère de gaz inerte à des valeurs correspondant à un point de la zone T du diagramme proposé par J.A. Thornton dans la revue Ann. Rev. Mater. Sci. 1977, page 242, de manière à conférer audit revêtement une distribution ultrafine de particules dures dans une matrice d'alliage et une structure compacte.

2. Procédé suivant la revendication 1, caractérisé en ce que ledit alliage présente une composition contenant 2 à 3 % de carbone, 40 à 55 % de cobalt, 25 à 35 % de chrome, 10 à 20 % de tungstène et 15 % de molybdène.

3. Procédé suivant la revendication 2, caractérisé en ce que ledit alliage comporte également 4 % de fer, de nickel et de titane.

4. Procédé selon l'une quelconque des revendications précédentes, caractérisé en ce qu'il consiste à déposer sur le revêtement (3) à distribution ultrafine de matériaux durs une couche de décoration (2) résistant à l'usure.

5. Procédé selon la revendication 4, caractérisé en ce que ladite couche de décoration est une couche TiN.

6. Procédé selon l'une quelconque des revendications précédentes, caractérisé en ce que l'on utilise un substrat (1) en laiton et en ce qu'une couche intermédiaire (4) formant barrière de diffusion est déposée sur le substrat (1) avant le dépôt du revêtement (3) à distribution ultrafine de matériaux durs.

7. Procédé selon la revendication 6, caractérisé en ce que ladite couche intermédiaire (4) est une couche de molybdène.

8. Piéce obtenue par le procédé suivant l'une quelconque des revendications 1 à 7, caractérisée en ce que la taille des particules dures formant la distribution ultrafine dudit revêtement (3) est inférieure à 0,01 μm.

9. Pièce selon la revendication 8, caractérisée en ce que ladite taille est inférieure à 0,005 μm.

10. Pièce selon l'une quelconque des revendications 8 et 9 caractérisé en ce que le revêtement (3) à distribution ultrafine de particules dures présente une épaisseur comprise entre 2 et 100 μm.

11. Pièce selon la revendication 10, caractérisée en ce que ladite épaisseur est comprise entre 5 et 15 μm.

12. Pièce obtenue par le procédé selon l'une quelconque des revendications 6 ou 7, caractérisée en ce que l'épaisseur de la couche intermédiaire (4) est comprise entre 0,1 et 0,5 μm.

13. Pièce selon l'une quelconque des revendications 8 à 12, caractérisée en ce qu'elle constitue un article de bijouterie.

**Patentansprüche**

1. Verfahren zur Herstellung eines Stückes mit einem metallischen Substrat, das mit einem harten und korrosionsfesten Überzug versehen ist, bei dem man in einem Raum, in dem eine Inertgasatmosphäre vorliegt, auf das metallische Substrat (1) dieses Stückes durch plasmaunterstütztes Niederschlagen (plasma assisted

4

deposition) einer Legierung einen metallischen Überzug (3) aufbringt, dadurch gekennzeichnet, daß die Legierung ein Stellit ist und daß das Verfahren im übrigen darin besteht, während des Niederschlagens die Temperatur des Substrates und den Inertgasdruck auf Werten zu halten, die einen Punkt der Zone T des von J.A. Thornton in revue Ann. Rev. Mater. Sci. 1977, Seite 242 vorgeschlagenen Diagramm entsprechen, um so dem Überzug eine ultrafeine Verteilung der harten Teilchen in einer Legierungsmatrix und eine kompakte Struktur zu geben.

2. Verfahren nach Anspruch 1, dadurch gekennzeichnet, daß die Legierung eine Zusammensetzung enthaltend 2 bis 3 % Kohlenstoff, 40 bis 55 % Kobalt, 25 bis 35 % Chrom, 10 bis 20 % Wolfram und 15 % Molybdän enthält.

3. Verfahren nach Anspruch 2, dadurch gekennzeichnet, daß die Legierung zusätzlich 4 % Eisen, Nickel und Titan enthält.

4. Verfahren nach einem der vorhergehenden Ansprüche, dadurch gekennzeichnet, daß man auf den Überzug (3) mit ultrafeiner Verteilung von Hartstoffen eine dekorative Lage (2), die abriebbeständig ist, niederschlägt.

5. Verfahren nach Anspruch 4, dadurch gekennzeichnet, daß die dekorative Lage eine Lage aus TiN ist.

6. Verfahren nach einem der vorhergehenden Ansprüche, dadurch gekennzeichnet, daß man ein Substrat (1) aus Messing verwendet, und daß auf das Substrat (1) vor dem Niederschlagen des Überzuges (3) mit ultrafeiner Verteilung von Hartstoffen eine Zwischenlage (4) niedergeschlagen wird, die eine Difusionssperre bildet.

7. Verfahren nach Anspruch 6, dadurch gekennzeichnet, daß die Zwischenlage eine Lage aus Molybdän ist.

8. Stück, erhalten durch das Verfahren nach einem der Ansprüche 1 bis 7, dadurch gekennzeichnet, daß die Größe der harten Teilchen, welche die ultrafeine Verteilung des Überzuges (3) bilden, kleiner als 0,01 µm ist.

9. Stück nach Anspruch 8, dadurch gekennzeichnet, daß die Größe kleiner als 0,005 µm ist.

10. Stück nach einem der Ansprüche 8 und 9, dadurch gekennzeichnet, daß der Überzug (3) mit ultrafeiner Verteilung von Hartteilchen eine Dicke zwischen 2 und 100 µm aufweist.

11. Stück nach Anspruch 10, dadurch gekennzeichnet, daß die Dicke zwischen 5 und 15 µm liegt.

12. Stück, erhalten durch das Verfahren nach einem der Ansprüche 6 oder 7, dadurch gekennzeichnet, daß die Dicke der Zwischenlage (4) zwischen 0,1 und 0,5 µm liegt.

13. Stück nach einem der Ansprüche 8 bis 12, dadurch gekennzeichnet, daß es einen Schmuckgegenstand darstellt.

## Claims

1. A process for the manufacture of an article comprising a metallic substrate provided with a hard and corrosion-proof coating consisting in applying to this metal substrate (1) of this article a metal coating (3) by plasma assisted deposition of an alloy in a chamber containing an inert gas atmosphere, characterized in that said alloy is a Stellite and in that the process consists, in addition, of maintaining the temperature of the substrate and the pressure of the inert gas atmosphere during deposition at values corresponding to a point in the T zone of the diagram proposed by J.A. Thornton in the journal Ann. Rev. Mater. Sci. 1977, page 242 in such a way as to confer to said coating an ultrafine distribution of hard articles in an alloy matrix and a compact structure.

2. A process according to claim 1, characterized in that said alloy is composed of 2 to 3 % carbon, 40 to 55 % cobalt, 25 to 35 % chromium, 10 to 20 % tungsten and 15 % molybdenum.

3. A process according to claim 2, characterized in that said alloy also includes 4 % iron, nickel and titanium.

4. A process according to any one of the preceding claims, characterized by depositing on the coating (3) of ultrafine distribution of hard materials a decorative layer (2) resistant to wear and tear.

5. A process according to claim 4, characterized in that said decorative layer is a layer of TiN.

6. A process according to any one of the preceding claims, characterized in that a substrate (1) of brass is used and in that an intermediate layer (4) forming a diffusion barrier is deposited on the substrate (1) before deposition of the coating (3) of ultrafine distribution of hard materials.

7. A process according to claim 6, characterized in that said intermediate layer (4) is a layer of molybdenum.

8. An article obtained by the process according to any one of claims 1 to 7, characterized in that the size of the hard particles forming the ultrafine distribution of said coating (3) is less than 0.01 µm.

9. An article according to claim 8, characterized in that said size is less than 0.005 µm.

10. An article according to either of claims 8 and 9, characterized in that the coating (3) of ultrafine distribution of hard particles displays a thickness of between 2 and 100 µm.

11. An article according to claim 10, characterized in that said thickness is between 5 and 15 µm.

12. An article obtained using to the process according to either of claims 6 or 7, characterized in that the thickness of the intermediate layer (4) is between 0.1 and 0.5 µm.

13. An article according to any one of claims 8 to 12, characterized in that it constitutes an article of jewellery.

Fig.1

Fig.2

Fig.3

Fig.4

Fig.5

## FIG. 6